# EUROPEAN PATENT APPLICATION

(11) **EP 4 844 958 A1**
(43) Date of publication of application: **25.11.2026**
(21) Application number: 25178460.9
(22) Date of filing: 23.05.2025
(51) Int. Cl.: H01R 13/52, H01R 13/453, B26B 19/38, H05K 5/00, H05K 5/06, H01R 24/60

(54) **FLUID-TIGHT SEALING OF ELECTRIC CONTACTS OF A CONNECTION PORT OF AN ELECTRIC APPLIANCE**

(71) Applicant: Koninklijke Philips N.V., 5656 AE Eindhoven (NL)
(72) Inventor: LOCHTMANS, Petrus Jean-Michael Laurentius, 5656 AG Eindhoven (NL); BROWN, Guy Anthony, 5656 AG Eindhoven (NL); VRIELINK, Riëlle Annabel, 5656 AG Eindhoven (NL); HOEXUM, Everhardus Johannes, 5656 AG Eindhoven (NL); KARTOZIYA, Inga, 5656 AG Eindhoven (NL); TAMMINGA, Stephanus Jacob Gerardus, 5656 AG Eindhoven (NL)
(74) Representative: Philips Intellectual Property & Standards

(57) **Abstract**

A connection port (1) of an electric appliance is equipped with a sealing arrangement (6) comprising at least one primary sealing element (20). The sealing arrangement (6) is made to function automatically when a connector (4) of an electric connection cable (5) is inserted into the connection port (1) and removed from the connection port (1). In particular, the at least one primary sealing element (20) is configured and arranged to cover and to be in direct fluid-tight sealing contact with one or more electric contacts (13) provided on a main surface (11, 12) of a plate-shaped carrier (10) of the connection port (1) in a default position; to be pushed away from the default position by the connector (4) when the connector (4) is inserted into the connection port (1); and to reassume the default position when the connector (4) is removed from the connection port (1).

## Description

### FIELD OF THE INVENTION

The invention relates to an electric appliance having a connection port, wherein the connection port comprises a plate-shaped carrier having two main surfaces, wherein at least one of said two main surfaces is provided with electric contacts, and wherein the plate-shaped carrier is arranged behind an insert opening in a main housing of the electric appliance for engagement with a connector of an external connection cable.

### BACKGROUND OF THE INVENTION

Use of an external connection cable with an electric appliance is common and well known. This serves various purposes, such as charging a battery of the electric appliance, in which case the external connection cable is functional to electrically connect the battery of the electric appliance to the mains or another source of electric power. In many practical cases, the electric appliance is equipped with a connection port which is designed to receive the connector of the external connection cable and to ensure that proper electric connection of the connector to an appropriate connection arrangement of the electric appliance is realized each time the connector of the external connection cable is inserted. In this respect, it is noted that the invention is in the context of electric appliances in which the connection arrangement mentioned here before is a plate-shaped carrier having two main surfaces, wherein at least one of said two main surfaces is provided with electric contacts. In view of various aspects such as durability and reliability of such a connection arrangement, it is advantageous if the plate-shaped carrier is arranged behind an insert opening in a main housing of the electric appliance.

Practical examples of a connection port as described here before are a USB-type connection port, a HDMI-type connection port and a Display Port-type connection port. Various variants of a USB-type connection port are known in the art, including a USB-A connection port, a USB-B connection port, a USB-C connection port, a USB mini connection port and a USB micro connection port.

A practical example of an electric appliance is a personal care appliance such as a shaver. A problem associated with a connection port of a personal care appliance is that a personal care device may get wet during use and that water ingress may occur at the position of the connection port. When the connection port gets wet, indeed, this causes an increase of a risk of corrosion of the electric contacts of the connection port. Corrosion increases the electrical resistance of the electric contacts, so that eventually there is an increased risk of overheating of the connection port and other parts and components close to the connection port. This may cause malfunctioning of the personal care appliance.

Various solutions aimed at keeping a connection port of an electric appliance dry have been developed in the art. For example, it is known to provide a cover or a cap configured to cover the insert opening for the connection port. A cover or a cap may function well to prevent water ingress, but relying on a cover or a cap involves a risk that users forget to put the cover or the cap in place, or that users wilfully refrain from using the cover or the cap because they do not like to make an additional effort and/or are not fully convinced that the cover or the cap has an important protective function.

It is an object of the invention to provide a solution to the problems associated with the possible ingress of water in a connection port of an electric appliance, particularly a solution which works automatically and under all circumstances, i.e., without a need for action from a user, and which yields good and reliable results.

### SUMMARY OF THE INVENTION

The invention provides an electric appliance having a connection port, wherein:
- the connection port comprises a plate-shaped carrier having two main surfaces, wherein at least one of said two main surfaces is provided with electric contacts, and wherein the plate-shaped carrier is arranged behind an insert opening in a main housing of the electric appliance for engagement with a connector of an external connection cable, and
- the connection port comprises a sealing arrangement comprising at least one primary sealing element which is configured and arranged:
- to cover and to be in direct fluid-tight sealing contact with at least some of the electric contacts on said at least one main surface of the plate-shaped carrier in a default position;
- to be pushed away from the default position by the connector of the external connection cable when the connector is inserted into the connection port via the insert opening to allow the connector to engage with the plate-shaped carrier and the electric contacts provided thereon; and
- to reassume the default position when the connector of the external connection cable is removed from the connection port.

According to the invention, the connection port comprises a sealing arrangement of a specific design, namely, a design in which the sealing arrangement comprises at least one primary sealing element which is configured and arranged to fulfill the functions defined here before. As a result, at least some of the electric contacts of the connection port are sealed in a fluid-tight fashion during times of absence of the connector of the external connection cable. This implies that at least some of the electric contacts are prevented from getting damp or wet during those times, even in a case of water ingress in the connection port. In a process of designing the sealing arrangement, information about which one(s) of the electric contacts are critical as far as fluid-tight sealing is concerned and which one(s) are not can be taken into account, and the at least one primary sealing element can be made to cover and to be in direct fluid-tight sealing contact with no more than the critical electric contacts. On the other hand, it is possible that the at least one primary sealing element is configured and arranged to cover and to be in direct fluid-tight sealing contact with all of the electric contacts on said at least one main surface of the plate-shaped carrier in the default position. In any case, the at least one primary sealing element is capable of being pushed away from the default position and to reassume the default position upon insertion into the connection port and removal from the connection port, respectively, of the connector of the external connection cable.

When the invention is put to practice, a connection port is realized in which some or all of the electric contacts of the connection port are kept free from possible influences of water (vapor), without a need for active intervention by a user. Use is made of a sealing arrangement comprising at least one primary sealing element, which at least one primary sealing element is at an appropriate position relative to the plate-shaped carrier and the electric contacts provided thereon, namely, a default position in which the at least one primary sealing element covers and is in direct fluid-tight sealing contact with at least some of the electric contacts when the connector of the external connection cable is absent, and a position of being pushed away from the default position when the connector is inserted into the connection port and engages with the plate-shaped carrier and the electric contacts. A practical example of the plate-shaped carrier is a printed circuit board assembly (PCBA), and the electric contacts can be provided as electrically conductive tracks on the PCBA.

It is to be noted that in the context of the invention, the following two main options exist: 1) the electric contacts are provided on only one of the two main surfaces of the plate-shaped carrier and the sealing arrangement comprises a primary sealing element which is arranged to cover and to be in direct fluid-tight sealing contact with said one main surface of the plate-shaped carrier, and 2) the electric contacts are provided on both main surfaces of the plate-shaped carrier and the sealing arrangement comprises two primary sealing elements each being arranged to cover and to be in direct fluid-tight sealing contact with a respective one of the two main surfaces of the plate-shaped carrier.

In an advantageous embodiment of the electric appliance according to the invention, the at least one primary sealing element is made from a flexible material. In this respect, it may be so that the flexible properties of the at least one primary sealing element are such that the at least one primary sealing element contacts the appropriate one or more of the electric contacts with force in the default position and has a tendency to flex back to the default position in a condition of being pushed away from the default position. Additionally or alternatively, it is possible that the sealing arrangement comprises a biasing mechanism which is configured and arranged:
- to bias the at least one primary sealing element towards the default position to enable the at least one primary sealing element to reassume the default position when the connector of the external connection cable is removed from the connection port; and
- to enable the at least one primary sealing element to exert a pressure force on the at least one main surface of the plate-shaped carrier in the default position.

Such a biasing mechanism may comprise one or more springs of a suitable type. For example, a construction is feasible in which the biasing mechanism comprises a leaf spring which is over-molded with the at least one primary sealing element, wherein the primary sealing element is in the form of a strip of a flexible material such as silicone.

The fluid-tight protective functionality of the sealing arrangement is further extended if the sealing arrangement is configured and arranged to realize a gradual exposure of the at least one main surface of the plate-shaped carrier in a direction away from the insert opening when the at least one primary sealing element is being pushed away from the default position by the connector of the external connection cable, and to realize a gradual coverage of said at least one main surface of the plate-shaped carrier in a direction towards the insert opening when the at least one primary sealing element is reassuming the default position. The fact is that a sealing arrangement which is capable to move in the way and the directions as described, acts to push water as may be present on the plate-shaped carrier in a direction towards the insert opening every time before reassuming the default position. This means that the risk that water as may be introduced in the connection port by the connector of the external connection cable or otherwise is enabled to travel further inwards and/or stay on one or more electric contacts is minimized or eliminated.

For further protection of the electric contacts against possible influences of water (vapor), it is advantageous if the sealing arrangement further comprises a secondary sealing element which is configured and arranged to function as an interior seal for the insert opening in the default position of the at least one primary sealing element.

The at least one primary sealing element may be of any suitable design. It may be beneficial to the protective function of the at least one primary sealing element if the at least one primary sealing element, at a side thereof facing the plate-shaped carrier, has a geometry which is complementary to a geometry of the at least one main surface of the plate-shaped carrier and/or the electric contacts on the at least one main surface of the plate-shaped carrier. A pattern of elevated and recessed areas on the at least one primary sealing element at the respective side may practically be a negative of a pattern of elevated and recessed areas on the at least one main surface of the plate-shaped carrier.

A first option in respect of the way in which the at least one primary sealing element is mounted is an option according to which the sealing arrangement further comprises a supporting member supporting the at least one primary sealing element, wherein a base portion of said supporting member is mounted in a fixed position relative to the main housing of the electric appliance. A second option is more sophisticated and is an option according to which the sealing arrangement further comprises a displaceable internal frame which is moveably guided within the main housing of the electric appliance in a direction parallel to a direction of insertion of the connector of the external connection cable into the insert opening, and which is urged towards the insert opening into a rest position under influence of a biasing force when the connector is not inserted into the connection port, wherein the sealing arrangement further comprises a supporting member supporting the at least one primary sealing element, and wherein a base portion of said supporting member is mounted in a fixed position to the displaceable internal frame. Both in the case of the first option and in the case of the second option, the supporting member may be integrally formed with or may be a portion of the primary sealing element, or the supporting member may be formed as a separate element to which the primary sealing element is mounted.

In the case of the above-mentioned second option, for example, the main housing comprises a tube-shaped interior portion and the displaceable internal frame is slidable within the tube-shaped interior portion, wherein a spring arrangement is arranged between the displaceable internal frame and an end portion of the tube-shaped interior portion to provide the biasing force. In any case, the design of the displaceable internal frame can be chosen such that an inserted connector of an external connection cable is fully supported by the displaceable internal frame, so that a situation in which the connector is at least partially supported by the plate-shaped carrier and thereby exerts force on a mounting construction of the plate-shaped carrier is avoided. Further, it is practical if the displaceable internal frame and the at least one primary sealing element are arranged so as to enable a procedure according to which the connector of the external connection cable, after insertion of the connector into the connection port, first engages the sealing arrangement to push the at least one primary sealing element away from the default position, and subsequently pushes the displaceable internal frame away from the insert opening to allow the connector to engage with the plate-shaped carrier and the electric contacts on the plate-shaped carrier.

It is advantageous if the user is enabled to insert the connector of the external connection cable into the connection port via the insert opening in a smooth fashion and without experiencing much counterforce. In this respect, it is possible that at least in the case of the first, relatively uncomplicated option mentioned here before, the sealing arrangement further comprises an abutment portion provided in a fixed position relative to the at least one primary sealing element for sliding engagement with the connector of the external connection cable, wherein the abutment portion is located in the insert opening and has an abutment surface having an inclined orientation relative to a direction of insertion of the connector into the insert opening. In a comparable fashion, in the case of the second, more sophisticated option mentioned here before, it is possible that the sealing arrangement further comprises an abutment portion provided in a fixed position relative to the at least one primary sealing element for sliding engagement with the connector of the external connection cable, wherein the abutment portion has an abutment surface having an inclined orientation relative to the direction of insertion of the connector, and wherein, in the rest position of the displaceable internal frame, the abutment portion is arranged behind the insert opening. Both in the case of the first option and in the case of the second option, the abutment portion may be integrally formed on the primary sealing element or may be formed as a separate portion mounted to the primary sealing element. In the case of the second option, the abutment portion is arranged behind the insert opening, so that the dimensions of the insert opening do not need to be adapted to accommodate the abutment portion or to allow the required displacement of the abutment portion. In the case of the second option, the displaceable internal frame may be designed to receive and support the connector of the external connection cable at the insert opening, so that the displaceable internal frame may subsequently support and guide the connector along a predefined path towards the abutment portion and the plate-shaped carrier arranged at respective distances behind the insert opening.

In a process of designing the connection port according to the invention, it may be useful to consider use of hydrophobic material at one or more appropriate positions in the connection port for even further reducing the risk of critical areas getting damp or wet.

The electric appliance of the invention can be any type of appliance, such as a personal care appliance. A well-known example of a personal care appliance is a shaver. In many known cases, it is practical if the electric appliance comprises a battery and the connection port is configured to be functional as a charging port for charging the battery. The connection port of the electric appliance can be of any type. Practical examples covered by the invention are a USB-type connection port, a HDMI-type connection port and a Display Port-type connection port. The USB-type connection port may be a USB-A connection port, a USB-B connection port, a USB-C connection port, a USB mini connection port and a USB micro connection port. The USB-A connection port, the USB mini connection port and the USB micro connection port are examples of a connection port having a plate-shaped carrier which is provided with electric contacts on only one of the two main surfaces thereof, while the USB-B connection port, the USB-C connection port and also the HDMI-type connection port and the Display Port-type connection port are examples of a connection port having a plate-shaped carrier which is provided with electric contacts on both main surfaces thereof.

The above-described and other aspects of the invention will be apparent from and elucidated with reference to the following detailed description of various embodiments of a connection port of an electric appliance.

### BRIEF DESCRIPTION OF THE DRAWINGS

The invention will now be explained in greater detail with reference to the figures, in which equal or similar parts are indicated by the same reference signs, and in which:
Fig. 1 diagrammatically shows a perspective view of components of a connection port of an electric appliance according to a first embodiment of the invention, a portion of a main housing of the electric appliance which serves to accommodate the components of the connection port, and a portion of an external connection cable including a connector which is to be inserted into the connection port via an insert opening in the main housing;
Figs. 2 and 3 diagrammatically show a perspective view and a sectional view, respectively, of the portion of the main housing of the electric appliance and the components of the connection port in an assembled condition, and the portion of the external connection cable;
Fig. 4 diagrammatically shows another sectional view of the portion of the main housing of the electric appliance and the components of the connection port in the assembled condition;
Figs. 5 and 6 illustrate different positions of the connector of the external connection cable relative to the connection port and associated configurations of the connection port;
Fig. 7 diagrammatically shows a perspective view of components of a connection port of an electric appliance according to a second embodiment of the invention, a portion of a main housing of the electric appliance which serves to accommodate the components of the connection port, and a portion of an external connection cable including a connector which is to be inserted into the connection port via an insert opening in the main housing;
Fig. 8 diagrammatically shows a sectional view of components of the connection port;
Figs. 9 and 10 diagrammatically show two design options in respect of a primary sealing element of a sealing arrangement of the connection port;
Figs. 11 and 12 diagrammatically show a perspective view and a sectional view, respectively, of the portion of the main housing of the electric appliance and the components of the connection port in an assembled condition, and the portion of the external connection cable;
Figs. 13-16 illustrate different positions of the connector of the external connection cable relative to the connection port and associated configurations of the connection port;
Fig. 17 shows an overview of three different configurations of the connection port;
Figs. 18 and 19 illustrate different positions of a connector of an external connection cable relative to a connection port of an electric appliance according to a third embodiment of the invention and associated configurations of the connection port; and
Figs. 20 and 21 illustrate different positions of a connector of an external connection cable relative to a connection port of an electric appliance according to a fourth embodiment of the invention and associated configurations of the connection port.

### DETAILED DESCRIPTION OF THE EMBODIMENTS

In the figures, four embodiments of a connection port 1 of an electric appliance are illustrated. In all four embodiments, the connection port 1 comprises a plate-shaped carrier 10 having two main surfaces 11, 12, wherein at least one of said two main surfaces 11, 12 is provided with electric contacts 13. For example, the connection port 1 may be a USB-type connection port, in which case the plate-shaped carrier 10 is a printed circuit board assembly (PCBA) and the electric contacts 13 are in the form of electrically conductive tracks. The electric appliance can be of any type including a main housing 2 for accommodating various components and possibly also for enabling a user of the electric appliance to take hold of the electric appliance. The latter is relevant in case the electric appliance is a handheld appliance such as a shaver or another type of handheld personal care appliance. In any case, in the context of the invention, the plate-shaped carrier 10 of the connection port 1 is arranged behind an insert opening 3 in the main housing 2 for engagement with a connector 4 of an external connection cable 5. The external connection cable 5 is used to establish a connection between the electric contacts 13 of the connection port 1 of the electric appliance on the one side and a respective arrangement on the other side, wherein a source of electric power and a device for storing and/or processing data are practical examples of such an arrangement.

In the context of the invention, measures aimed at preventing the electric contacts 13 of the connection port 1 from getting damp or wet are taken. In this respect, it is noted that the connection port 1 is equipped with a sealing arrangement 6. In all of the present four embodiments of the connection port 1 of the invention, the sealing arrangement 6 comprises at least one primary sealing element 20 which is functional to cover and to be in direct fluid-tight sealing contact with at least some of the electric contacts 13 in a default position. Further, the constitution of the primary sealing element 20 is such that when the connector 4 of the external connection cable 5 is inserted into the connection port 1 via the insert opening 3 in the main housing 2 to allow the connector 4 to engage with the plate-shaped carrier 10 and the electric contacts 13 provided thereon, the primary sealing element 20 is pushed away from the default position by the connector 4, and that when the connector 4 is removed from the connection port 1, the primary sealing element 20 reassumes the default position. The present four embodiments of the connection port 1 of the invention differ from each other at least as far as the constructional details of the sealing arrangement 6 are concerned, as will become apparent from the following description.

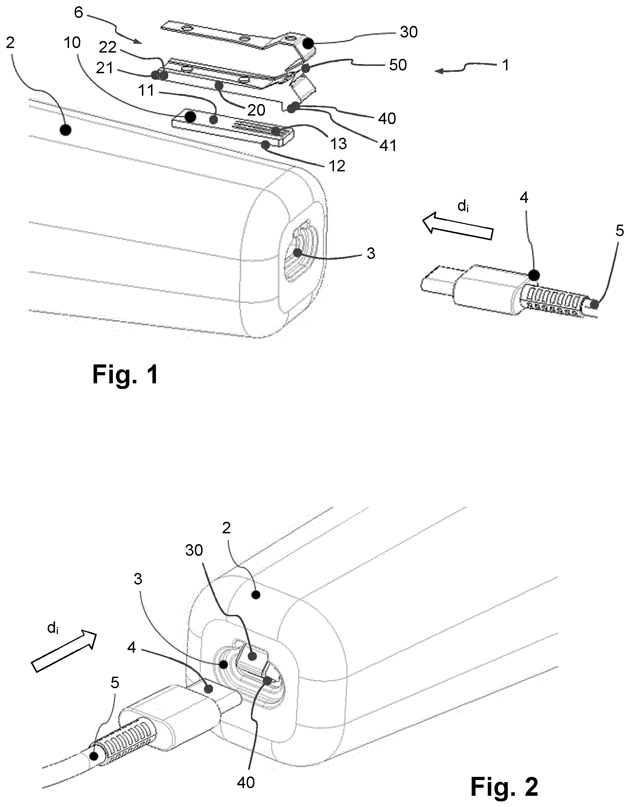

A first embodiment of the connection port 1 is illustrated in Figs. 1-6. In this embodiment, the sealing arrangement 6 comprises a single primary sealing element 20 which is located at the side of one main surface 11 of the plate-shaped carrier 10. The primary sealing element 20 comprises a strip of a flexible material such as silicone. Further, the sealing arrangement 6 comprises a leaf spring 30 which serves to bias the primary sealing element 20 towards the default position and to enable the primary sealing element 20 to exert a pressure force on the main surface 11 of the plate-shaped carrier 10 in the default position. The leaf spring 30 is over-molded with the strip of the flexible material of the primary sealing element 20. The assembly of the primary sealing element 20 and the leaf spring 30 is fixed to the main housing 2 at the position of a base portion 21 of a supporting member 22 included in the primary sealing element 20. For clarity reasons, the way in which the plate-shaped carrier 10 is mounted in the main housing 2 is not illustrated.

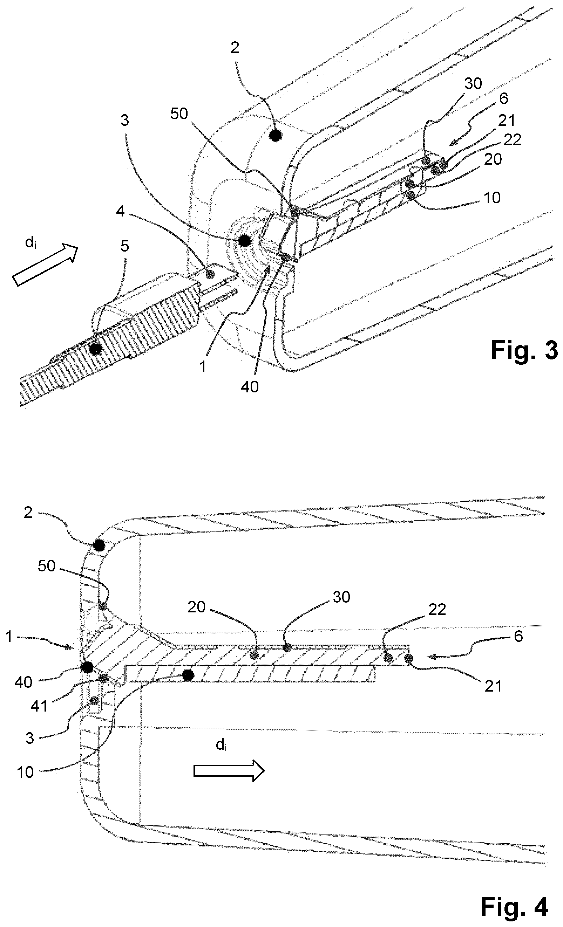

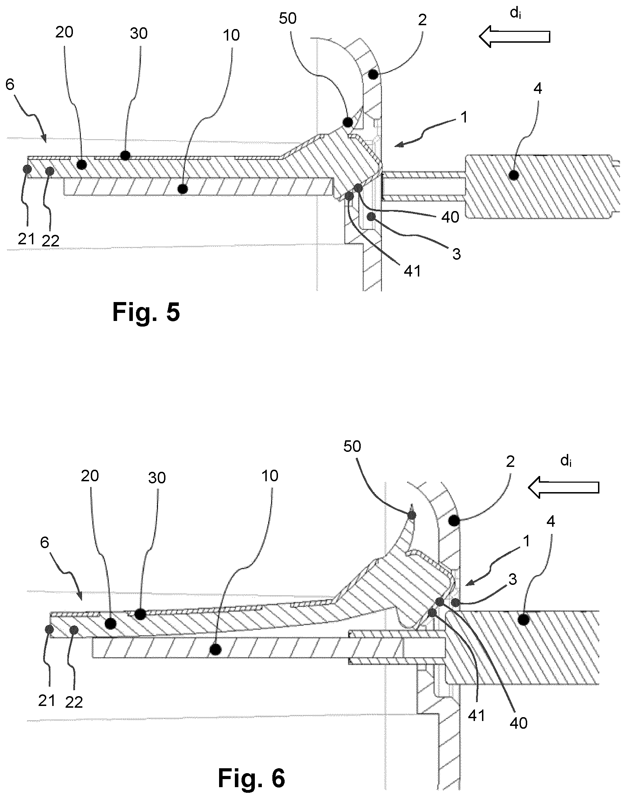

Figs. 3 and 4 provide a clear illustration of the default position of the primary sealing element 20. In Fig. 5, it can be seen how the connection port 1 is approached by the connector 4 of the external connection cable 5, and also that the primary sealing element 20 is in the default position as long as the connector 4 is still outside of the insert opening 3 in the main housing 2. In Fig. 6, it can be seen how the primary sealing element 20 is pushed away from the default position by the connector 4, against the action of the leaf spring 30, when the connector 4 is in a final position in the connection port 1, which is a position in which the plate-shaped carrier 10 is partially received in the connector 4. The free end of the assembly of the primary sealing element 20 and the leaf spring 30 has been pushed in a direction away from the plate-shaped carrier 10 as a result of being contacted by the inwardly moving connector 4. For the purpose of ensuring a smooth process of pushing the primary sealing element 20 away from the default position and minimizing force to be exerted by a user, it is advantageous if the sealing arrangement 6 further comprises an abutment portion 40 provided on the primary sealing element 20 for sliding engagement with the connector 4, as shown, which abutment portion 40 is located in the insert opening 3 and has an abutment surface 41 having an inclined orientation relative to a direction of insertion dᵢ of the connector 4 into the insert opening 3.

Another advantageous yet non-essential aspect of the sealing arrangement 6 of the connection port 1 of the first embodiment is that the sealing arrangement 6 further comprises a secondary sealing element 50 which is shaped like a flange to thereby function as an interior seal for the insert opening 3 in the default position of the primary sealing element 20. In Figs. 3-5, it can be seen how the secondary sealing element 50 closes a gap which is present between the abutment portion 40 of the primary sealing element 20 and the main housing 2 for leaving space for the displacement of the abutment portion 40 when the primary sealing element 20 is pushed away from the default position by the connector 4 as the connector 4 is advanced from the position outside of the insert opening 3 towards the final position.

When the connector 4 is retracted from the final position, the primary sealing element 20 automatically reassumes the default position as a result of the action of the leaf spring 30. In the process of reassuming the default position, the primary sealing element 20 gradually covers the main surface 11 of the plate-shaped carrier 10 in a direction towards the insert opening 3 as a result of the flexibility of the primary sealing element 20 and the fixing of the primary sealing element 20 to the main housing 2 at the base portion 21 of its supporting member 22 as described here before. This implies that even in a situation in which the connector 4 is at least partially wet and water has been introduced in the connection port 1 as a result, the water does not stay behind between the primary sealing element 20 and the electric contacts 13 on the main surface 11, but is pushed in the direction towards the insert opening 3 instead. Besides, to make a user aware of insertion of the connector 4 in a wet condition, other precautions such as issuance of a warning signal could be implemented to prevent oxidation of the electric contacts 13 and possible overheating.

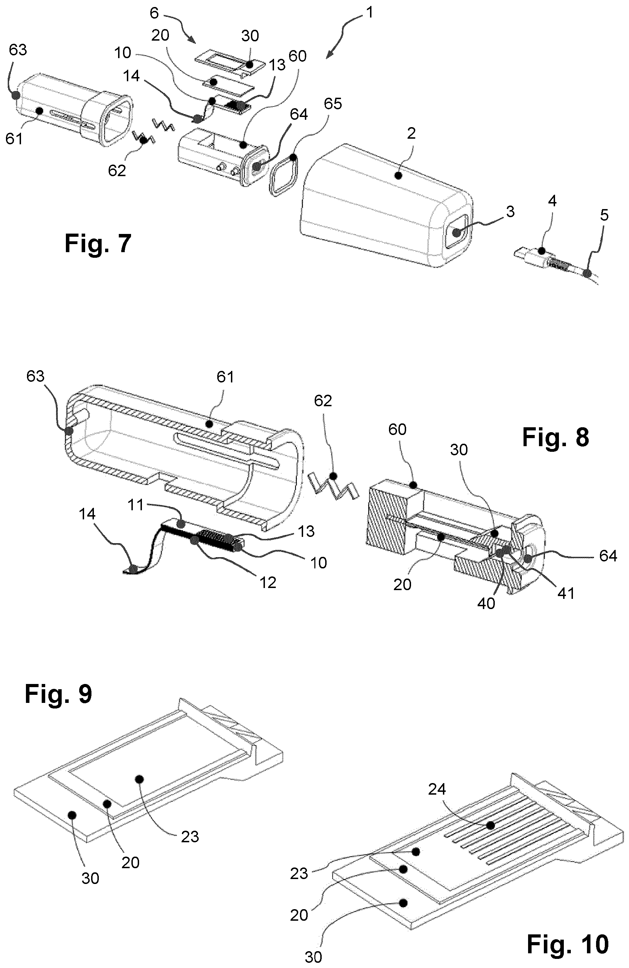

A second embodiment of the connection port 1 is illustrated in Figs. 7-17. In this embodiment, the sealing arrangement 6 comprises a single primary sealing element 20 which is located at the side of one main surface 11 of the plate-shaped carrier 10. The primary sealing element 20 comprises a strip of a flexible material such as silicone. Further, the sealing arrangement 6 comprises a leaf spring 30 which serves to bias the primary sealing element 20 towards the default position and to enable the primary sealing element 20 to exert a pressure force on the main surface 11 of the plate-shaped carrier 10 in the default position. The leaf spring 30 is over-molded with the strip of the flexible material of the primary sealing element 20.

Fig. 9 shows a first practical example of the assembly of the primary sealing element 20 and the leaf spring 30. In this example, the primary sealing element 20 is provided with a recess 23 to embed the plate-shaped carrier 10 in the default position for sealing. Thus, a side of the primary sealing element 20 facing the plate-shaped carrier 10 has a geometry which is complementary to a geometry of the main surface 11 of the plate-shaped carrier 10. Fig. 10 shows a second practical example of the assembly of the primary sealing element 20 and the leaf spring 30. In this example, compared to the first practical example, the primary sealing element 20 is further provided with a geometry of ribs 24 or another dedicated surface structure, to further improve the functionality of sealing in particular the electric contacts 13 on the main surface 11 of the plate-shaped carrier 10 and/or to further improve the functionality of pressing away water as may be present from critical areas, that is to say, on and near the electric contacts 13, to non-critical areas. In particular, the geometry of the ribs 24 may be complementary to a geometry of the electric contacts 13 on the main surface 11 of the plate-shaped carrier 10.

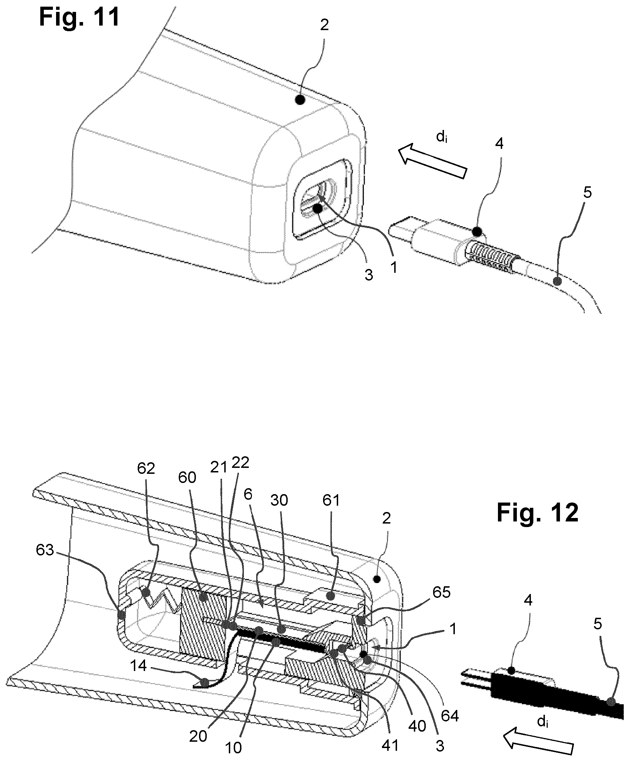

A notable feature of the connection port 1 of the second embodiment resides in the fact that the sealing arrangement 6 further comprises a displaceable internal frame 60, wherein the assembly of the primary sealing element 20 and the leaf spring 30 is fixed to the displaceable internal frame 60 at the position of a base portion 21 of a supporting member 22 included in the primary sealing element 20. In particular, the displaceable internal frame 60 is moveably guided within the main housing 2 in a direction parallel to the direction of insertion dᵢ of the connector 4 into the insert opening 3. In the present example, the displaceable internal frame 60 is slidable in a generally tube-shaped interior housing portion 61. The displaceable internal frame 60 is urged towards the insert opening 3 into a rest position under influence of a biasing force when the connector 4 is not inserted into the connection port 1. To this end, a spring arrangement 62 is arranged at a position between the displaceable internal frame 60 and a closed end 63 of the interior housing portion 61. In the present example, the spring arrangement 62 comprises two spring elements. The various components of the connection port 1 are shown in Fig. 7, wherein a portion of the main housing 2 of the electric appliance, a portion of the external connection cable 5 including the connector 4 and a portion of a cable 14 which is attached to the plate-shaped carrier 10 are shown as well. Fig. 8 shows a sectional view of the plate-shaped carrier 10 and the portion of the cable 14, the displaceable internal frame 60, the interior housing portion 61 and one of the spring elements of the spring arrangement 62. Fig. 11 provides an image of what the connection port 1 looks like on the outside in an assembled condition, while Fig. 12 provides an image of what the connection port 1 looks like on the inside in the assembled condition. It can be seen in Fig. 11 that in a situation in which the connector 4 of the external connection cable 5 is not inserted into the connection port 1, the displaceable internal frame 60 has a function in covering the insert opening 3 in the main housing 2 and thereby hiding the interior construction of the connection port 1 from view.

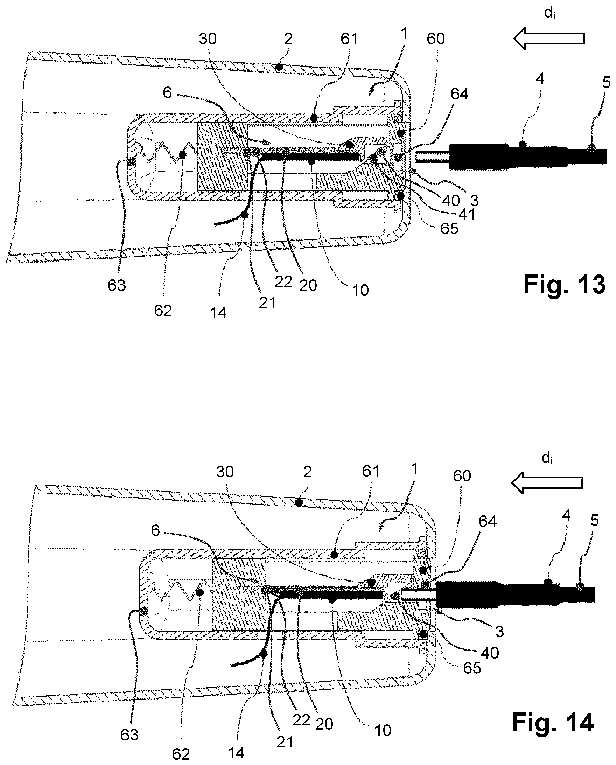

With reference to Figs. 13-16, various steps in a process of inserting the connector 4 of the external connection cable 5 into the connection port 1 and associated configurations of the connection port 1 are now described.

In Fig. 13, it can be seen how the connection port 1 is approached by the connector 4 of the external connection cable 5, and also that the primary sealing element 20 is in the default position and that the displaceable internal frame 60 is in the rest position as long as the connector 4 is still outside of the insert opening 3 in the main housing 2.

In Fig. 14, a first stage of insertion of the connector 4 is illustrated. This first stage ends when the front of the connector 4 abuts against an inclined abutment surface 41 of an abutment portion 40 provided on the primary sealing element 20. In the present example, the abutment portion 40 is an integral part of the leaf spring 30, which does not alter the fact that other possibilities are feasible as well. In the first stage of insertion, there are no changes in the configuration of the connection port 1 described here before with reference to Fig. 13.

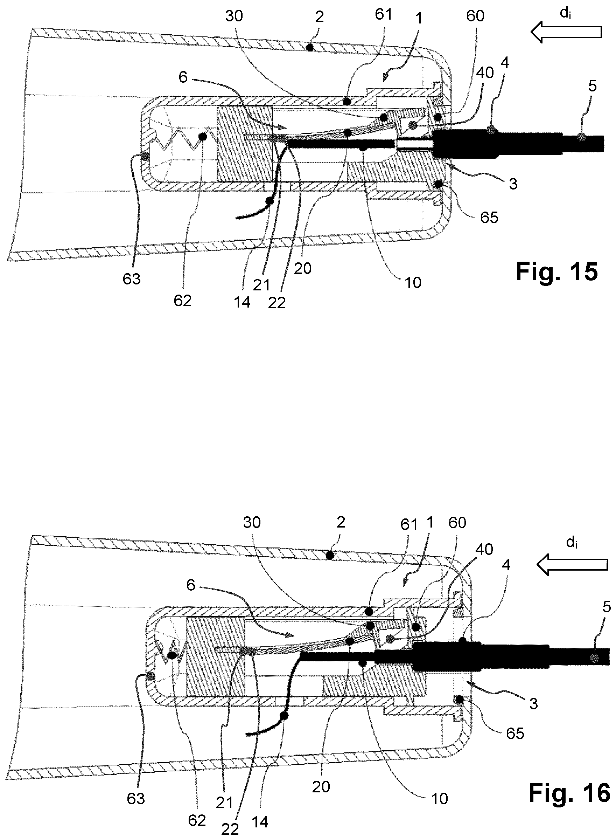

In Fig. 15, a second stage of insertion of the connector 4 is illustrated. This second stage ends when the connector 4 fully occupies an entrance space 64 of the displaceable internal frame 60 and the front of the connector 4 has reached the plate-shaped carrier 10. In the second stage of insertion, the primary sealing element 20 is pushed away from the default position under influence of sliding contact between the front of the connector 4 and the abutment surface 41 of the abutment portion 40, against the action of the leaf spring 30. As a result, space is available between the primary sealing element 20 and the main surface 11 of the plate-shaped carrier 10 so that the connector 4 is free to advance even further. The displaceable internal frame 60 is still in the rest position.

In Fig. 16, a third stage of insertion of the connector 4 is illustrated. This third stage ends when the connector 4 has reached the final position in the connection port 1. In the third stage of insertion, the position of the primary sealing element 20 from the second stage of insertion is maintained while the displaceable internal frame 60 is pushed to a position further towards the closed end 63 of the interior housing portion 61 by the advancing connector 4, against the action of the spring arrangement 62.

During both the second stage and the third stage of insertion of the connector 4 as described here before, the connector 4 is supported by the entrance space 64 of the displaceable internal frame 60. As a result, during the second and third stages of insertion, the connector 4 is supported and guided by the displaceable internal frame 60 along a predefined path towards the abutment portion 40 and the plate-shaped carrier 10, which are each arranged at a respective distance behind the insert opening 3. This will assist the user in correctly connecting the connector 4 to the plate-shaped carrier 10.

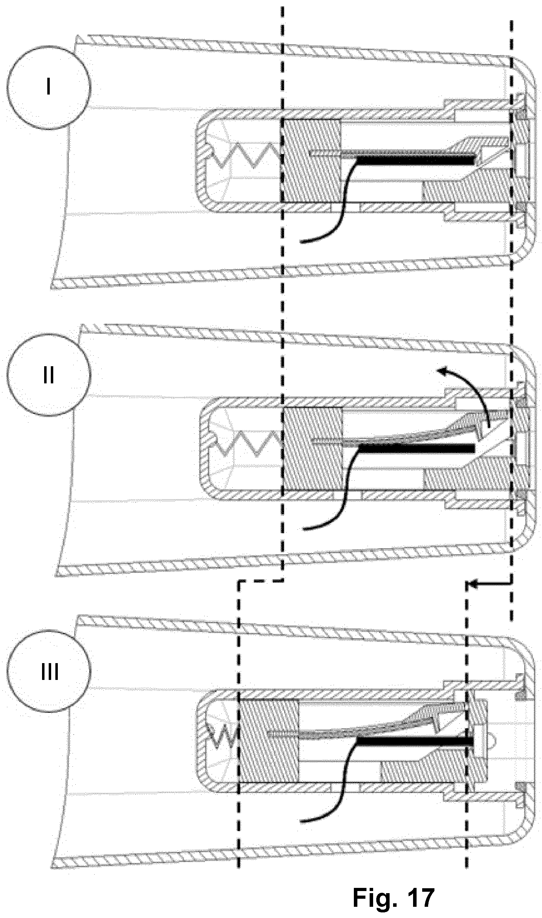

The respective stages of insertion described here before are indicated by I, II and III in Fig. 17. The respective stages of insertion are shown one below the other and the position of the displaceable internal frame 60 as seen in the direction of insertion dᵢ of the connector 4 into the insert opening 3 is indicated by means of dashed lining. The movement of the primary sealing element 20 away from the default position in the second stage of insertion is indicated by means of a bent arrow.

When the connector 4 is retracted from the final position, the primary sealing element 20 automatically reassumes the default position as a result of the action of the leaf spring 30, while the displaceable internal frame 60 automatically resumes the rest position as a result of the action of the spring arrangement 62. In the present example, the characteristics of the spring arrangement 62 are chosen such that the spring arrangement 62 is capable of pushing the displaceable internal frame 60 to the rest position in the situation that the connector 4 is retracted from the final position yet is not capable of pushing the connector 4 in the final position away from engagement on the plate-shaped carrier 10 through the displaceable internal frame 60. Advantageously, as shown in Figs. 12-16, a seal 65 is placed on the main housing 2 at a position where the displaceable internal frame 60 abuts against the main housing 2 when reaching the rest position to serve as a damper and to thereby prevent noise of operation.

The leaf spring 30 may comprise any suitable type of material, and may comprise a plastic frame, for example, to generate the spring force needed to hold the primary sealing element 20 in the default position when the connector 4 is absent. As the primary sealing element 20 is made of a highly flexible material such as silicone, the primary sealing element 20 is considered to add any resistant bending forces to the leaf spring 30 to no more than a neglectable extent. By tuning the spring force of the leaf spring 30 (material, length, width and thickness of the plastic frame components) to the spring force of the spring arrangement 62 acting on the displaceable internal frame 60 (material, thickness and length), the intended movement sequence described here before can be assured, i.e., the movement sequence in which the connector 4 first pushes the primary sealing element 20 away from the default position and subsequently pushes the displaceable internal frame 60 inwards to eventually enable establishment of the intended electric connection between the connector 4 and the electric contacts 13 of the connection port 1. As a result of the sequence in which lifting of the assembly of the primary sealing element 20 and the leaf spring 30 and pushing the displaceable internal frame 60 inwards take place in different stages of insertion, it is achieved that the primary sealing element 20 does not stick to the plate-shaped carrier 10 during the inward movement of the displaceable internal frame 60. This means that no other forces than the designed spring force of the spring arrangement 62 are hampering said movement, which contributes to a user-friendly character of the connection port 1.

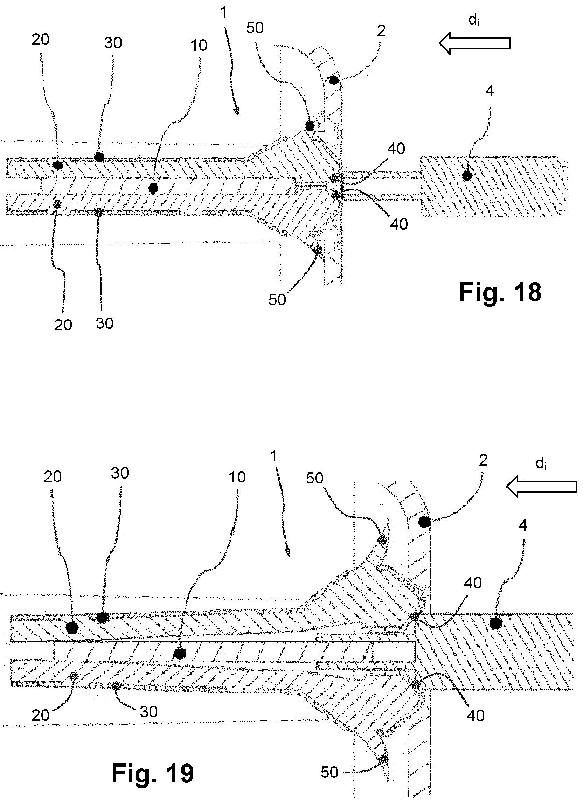

A third embodiment of the connection port 1 is illustrated in Figs. 18 and 19. In the connection port 1 of the third embodiment, the plate-shaped carrier 10 is provided with electric contacts 13 on both main surfaces 11, 12. In fact, the connection port 1 of the third embodiment can be regarded as a double realization of the connection port 1 of the first embodiment, comprising two sets of a primary sealing element 20, a leaf spring 30, an abutment portion 40 and a secondary sealing element 50, namely, one set arranged at the side of main surface 11 of the plate-shaped carrier 10, and the other set arranged at the side of the other main surface 12 of the plate-shaped carrier 10. Fig. 18 shows the connection port 1 with the two primary sealing elements 20 in the default position, and Fig. 19 shows the connection port 1 with an inserted connector 4 of an electric connection cable 5 in the final position and the two primary sealing elements 20 in a position of being pushed away from their default positions and thereby exposing the respective main surfaces 11, 12 of the plate-shaped carrier 10.

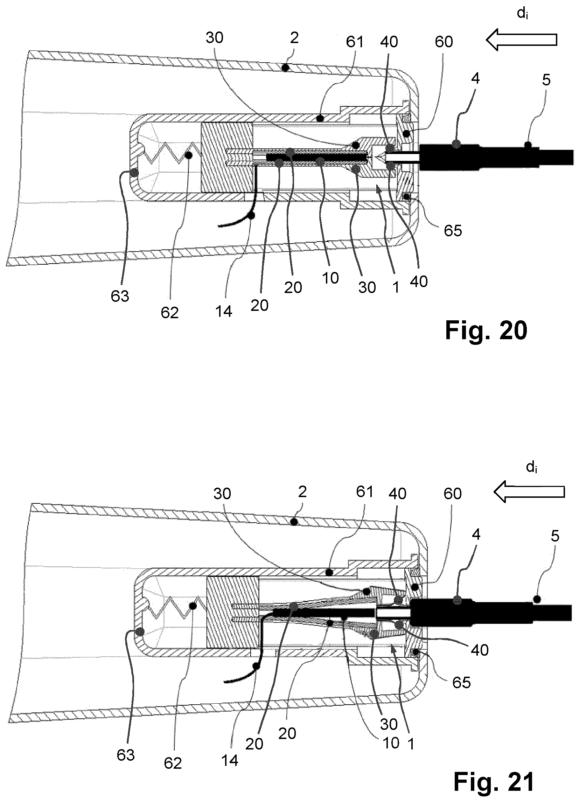

A fourth embodiment of the connection port 1 is illustrated in Figs. 20 and 21. In the connection port 1 of the fourth embodiment, the plate-shaped carrier 10 is provided with electric contacts 13 on both main surfaces 11, 12. In fact, the connection port 1 of the fourth embodiment can be regarded as a double realization of the connection port 1 of the second embodiment, comprising two sets of a primary sealing element 20, a leaf spring 30 and an abutment portion 40, namely, one set arranged at the side of main surface 11 of the plate-shaped carrier 10, and the other set arranged at the side of the other main surface 12 of the plate-shaped carrier 10. Fig. 20 shows the connection port 1 with the two primary sealing elements 20 in the default position, and Fig. 21 shows the connection port 1 with an inserted connector 4 of an electric connection cable 5 at the end of the second stage of insertion and the two primary sealing elements 20 in a position of being pushed away from the default position and thereby exposing the respective main surfaces 11, 12 of the plate-shaped carrier 10.

It will be clear to a person skilled in the art that the scope of the invention is not limited to the examples discussed in the foregoing, and that several amendments and modifications thereof are possible without deviating from the scope of the invention as defined in the attached claims. It is intended that the invention be construed as including all such amendments and modifications insofar they come within the scope of the claims or the equivalents thereof. While the invention has been illustrated and described in detail in the figures and the description, such illustration and description are to be considered illustrative or exemplary only, and not restrictive. The invention is not limited to the disclosed embodiments. The drawings are schematic, wherein details which are not required for understanding the invention may have been omitted, and not necessarily to scale.

Variations to the disclosed embodiments can be understood and effected by a person skilled in the art in practicing the claimed invention, from a study of the figures, the description and the attached claims. In the claims, the word "comprising" does not exclude other steps or elements, and the indefinite article "a" or "an" does not exclude a plurality. Any reference signs in the claims should not be construed as limiting the scope of the invention.

Elements and aspects discussed for or in relation with a particular embodiment may be suitably combined with elements and aspects of other embodiments, unless explicitly stated otherwise. Thus, the mere fact that certain measures are recited in mutually different dependent claims does not indicate that a combination of these measures cannot be used to advantage.

The terms "comprise" and "include" as used in the present text will be understood by a person skilled in the art as covering the term "consist of". Hence, the term "comprise" or "include" may in respect of an embodiment mean "consist of", but may in another embodiment mean "contain/have/be equipped with at least the defined species and optionally one or more other species".

Notable aspects of the invention are summarized as follows. In the field of connection ports of electric appliances, water ingress is an issue and is known to cause problems such as corrosion of electric contacts of the connection ports, which may result in increased electric resistance of the electric contacts and overheating, and even in failure of the connection ports. In order to overcome the problems, an advantageous set-up of a connection port 1 is proposed in which the connection port 1 is equipped with a sealing arrangement 6 comprising at least one primary sealing element 20. The sealing arrangement 6 is made to function automatically when a connector 4 of an electric connection cable 5 is inserted into the connection port 1 and removed from the connection port 1, without any need for intervention from a user. In particular, the at least one primary sealing element 20 is configured and arranged to cover and to be in direct fluid-tight sealing contact with one or more electric contacts 13 provided on a main surface 11, 12 of a plate-shaped carrier 10 of the connection port 1 in a default position; to be pushed away from the default position by the connector 4 of the external connection cable 5 when the connector 4 is inserted into the connection port 1; and to reassume the default position when the connector 4 of the external connection cable 5 is removed from the connection port 1.

## Claims

1. An electric appliance having a connection port (1), wherein:
- the connection port (1) comprises a plate-shaped carrier (10) having two main surfaces (11, 12), wherein at least one of said two main surfaces (11, 12) is provided with electric contacts (13), and wherein the plate-shaped carrier (10) is arranged behind an insert opening (3) in a main housing (2) of the electric appliance for engagement with a connector (4) of an external connection cable (5), and
- the connection port (1) comprises a sealing arrangement (6) comprising at least one primary sealing element (20) which is configured and arranged:
- to cover and to be in direct fluid-tight sealing contact with at least some of the electric contacts (13) on said at least one main surface (11, 12) of the plate-shaped carrier (10) in a default position;
- to be pushed away from the default position by the connector (4) of the external connection cable (5) when the connector (4) is inserted into the connection port (1) via the insert opening (3) to allow the connector (4) to engage with the plate-shaped carrier (10) and the electric contacts (13) provided thereon; and
- to reassume the default position when the connector (4) of the external connection cable (5) is removed from the connection port (1).

2. The electric appliance as claimed in claim 1, wherein the at least one primary sealing element (20) is made from a flexible material.

3. The electric appliance as claimed in claim 1 or 2, wherein the sealing arrangement (6) comprises a biasing mechanism (30) which is configured and arranged:
- to bias the at least one primary sealing element (20) towards the default position to enable the at least one primary sealing element (20) to reassume the default position when the connector (4) of the external connection cable (5) is removed from the connection port (1); and
- to enable the at least one primary sealing element (20) to exert a pressure force on the at least one main surface (11, 12) of the plate-shaped carrier (10) in the default position.

4. The electric appliance as claimed in any of claims 1-3, wherein the at least one primary sealing element (20) is configured and arranged to cover and to be in direct fluid-tight sealing contact with all of the electric contacts (13) on said at least one main surface (11, 12) of the plate-shaped carrier (10) in the default position.

5. The electric appliance as claimed in any of claims 1-4, wherein the sealing arrangement (6) is configured and arranged to realize a gradual exposure of the at least one main surface (11, 12) of the plate-shaped carrier (10) in a direction away from the insert opening (3) when the at least one primary sealing element (20) is being pushed away from the default position by the connector (4) of the external connection cable (5), and to realize a gradual coverage of said at least one main surface (11, 12) of the plate-shaped carrier (10) in a direction towards the insert opening (3) when the at least one primary sealing element (20) is reassuming the default position.

6. The electric appliance as claimed in any of claims 1-5, wherein the sealing arrangement (6) further comprises a secondary sealing element (50) which is configured and arranged to function as an interior seal for the insert opening (3) in the default position of the at least one primary sealing element (20).

7. The electric appliance as claimed in any of claims 1-6, wherein:
- the electric contacts (13) are provided on only one of the two main surfaces (11, 12) of the plate-shaped carrier (10) and the sealing arrangement (6) comprises a primary sealing element (20) which is arranged to cover and to be in direct fluid-tight sealing contact with said one main surface (11, 12) of the plate-shaped carrier (10); or
- the electric contacts (13) are provided on both main surfaces (11, 12) of the plate-shaped carrier (10) and the sealing arrangement (6) comprises two primary sealing elements (20) each being arranged to cover and to be in direct fluid-tight sealing contact with a respective one of the two main surfaces (11, 12) of the plate-shaped carrier (10).

8. The electric appliance as claimed in any of claims 1-7, wherein the at least one primary sealing element (20), at a side thereof facing the plate-shaped carrier (10), has a geometry which is complementary to a geometry of the at least one main surface (11, 12) of the plate-shaped carrier (10) and/or the electric contacts (13) on the at least one main surface (11, 12) of the plate-shaped carrier (10).

9. The electric appliance as claimed in any of claims 1-8, wherein the sealing arrangement (6) further comprises a supporting member (22) supporting the at least one primary sealing element (20), and wherein a base portion (21) of said supporting member (22) is mounted in a fixed position relative to the main housing (2) of the electric appliance.

10. The electric appliance as claimed in claim 9, wherein the sealing arrangement (6) further comprises an abutment portion (40) provided in a fixed position relative to the at least one primary sealing element (20) for sliding engagement with the connector (4) of the external connection cable (5), and wherein the abutment portion (40) is located in the insert opening (3) and has an abutment surface (41) having an inclined orientation relative to a direction of insertion (dᵢ) of the connector (4) into the insert opening (3).

11. The electric appliance as claimed in any of claims 1-8, wherein the sealing arrangement (6) further comprises a displaceable internal frame (60) which is moveably guided within the main housing (2) of the electric appliance in a direction parallel to a direction of insertion (dᵢ) of the connector (4) of the external connection cable (5) into the insert opening (3), and which is urged towards the insert opening (3) into a rest position under influence of a biasing force when the connector (4) is not inserted into the connection port (1), wherein the sealing arrangement (6) further comprises a supporting member (22) supporting the at least one primary sealing element (20), and wherein a base portion (21) of said supporting member (22) is mounted in a fixed position to the displaceable internal frame (60).

12. The electric appliance as claimed in claim 11, wherein the displaceable internal frame (60) and the at least one primary sealing element (20) are arranged so as to enable a procedure according to which the connector (4) of the external connection cable (5), after insertion of the connector (4) into the connection port (1), first engages the sealing arrangement (6) to push the at least one primary sealing element (20) away from the default position, and subsequently pushes the displaceable internal frame (60) away from the insert opening (3) to allow the connector (4) to engage with the plate-shaped carrier (10) and the electric contacts (13) on the plate-shaped carrier (10).

13. The electric appliance as claimed in claim 11 or 12, wherein the sealing arrangement (6) further comprises an abutment portion (40) provided in a fixed position relative to the at least one primary sealing element (20) for sliding engagement with the connector (4) of the external connection cable (5), wherein the abutment portion (40) has an abutment surface (41) having an inclined orientation relative to the direction of insertion (dᵢ) of the connector (4), and wherein, in the rest position of the displaceable internal frame (60), the abutment portion (40) is arranged behind the insert opening (3).

14. The electric appliance as claimed in any of claims 1-13, further comprising a battery, wherein the connection port (1) is configured to be functional as a charging port for charging the battery.

15. The electric appliance as claimed in any of claims 1-14, wherein the connection port (1) is one of a USB-type connection port, a HDMI-type connection port and a Display Port-type connection port.
